# EUROPÄISCHE PATENTSCHRIFT

(11) **EP 3 387 514 B1**
(45) Veröffentlichungstag und Bekanntmachung des Hinweises auf die Patenterteilung: **26.06.2019**
(21) Anmeldenummer: 16801711.9
(22) Anmeldetag: 21.11.2016
(51) Int. Cl.: G06F 3/01, H03K 17/96

(54) **HAPTISCHE RÜCKMELDUNG BEI EINER NUTZERSCHNITTSTELLE**
HAPTIC FEEDBACK IN A USER INTERFACE
RÉTROACTION HAPTIQUE D'UNE INTERFACE UTILISATEUR

(30) Priorität: 12.12.2015 DE 102015016152
(43) Veröffentlichungstag der Anmeldung: 17.10.2018
(73) Patentinhaber: Daimler AG, 70327 Stuttgart (DE)
(72) Erfinder: PLEWE, Marco, Sunnyvale, CA 94085 (US); PLEWE, Sarah, Sunnyvale, CA 94306 (US); REISINGER, Jörg, 74369 Löchgau (DE)
(74) Vertreter: JENSEN & SON
(86) Internationale Anmeldenummer: PCT/EP2016/001959
(87) Internationale Veröffentlichungsnummer: WO 2017/097399

(56) Entgegenhaltungen:
- EP-A1- 2 117 122
- EP-A1- 2 518 588
- WO-A1-2007/128633
- AU-A4- 2015 101 188
- DE-A1-102009 026 408
- US-A1- 2016 195 931

## Beschreibung

Die Erfindung betrifft ein Verfahren zur Steuerung eines Aktors, der mit einem Bedienelement einer manuellen Nutzerschnittstelle verbunden ist, und der zur Ausgabe eines haptischen Rückmeldesignals S_{A}(t) über das Bedienelement an einen Nutzer dient. Weiterhin betrifft die Erfindung eine manuelle Nutzerschnittstelle umfassend ein Bedienelement zur manuellen Eingabe durch einen Nutzer und einen mit dem Bedienelement verbundenen Aktor zur Ausgabe eines haptischen Rückmeldesignals S_{A}(t) über das Bedienelement an den Nutzer.

Die Erfindung findet Verwendung bei jedweden manuellen Nutzerschnittstellen, die zur Ausgabe eines haptischen Rückmeldesignals ausgebildet sind, wobei das haptische Rückmeldesignal insbesondere Informationen über einen aktuellen Zustand der manuellen Nutzerschnittstelle bzw. des Bedienelements angibt. Die manuellen Bedienelemente können dabei beispielsweise als Taster, als berührempfindliche Oberfläche, als Schalter, als Computermaus, als Joystick, etc. ausgebildet sein.

Aus der EP 2 117 122 A1 ist hierzu eine Anordnung und ein Verfahren zur haptischen und/oder akustischen Rückmeldung an sensorischen Bedienelementen bekannt. Die darin offenbarte Anordnung zur Rückmeldung der Betätigung an sensorischen Bedienelementen umfasst mindestens eine Trägerplatte als Bedienelement; einen an der Trägerplatte angeordneten Sensor; mindestens einen breitbandigen elektromechanischen und/oder elektroakustischen Signalwandler, vorzugsweise eine Schwingspule, die der mindestens einen Trägerplatte zugeordnet ist, und eine Steuereinheit, die mit dem Sensor und der Schwingspule elektrisch verbunden ist und zur Auswertung der von dem Sensor abgegebenen Sensorsignale und zur Erzeugung mindestens eines haptischen und/oder akustischen Rückmeldesignals eingerichtet ist.

Für derartige Anordnungen, wie sie in der EP 2 117 122 A1 offenbart sind, wird auch der Begriff "haptische Nutzerschnittstelle" verwendet. Solche "haptischen Nutzerschnittstellen" ermöglichen es, dass ein Nutzer zur gleichen Zeit, während er das Bedienelement manuell betätigt, taktile oder kinetische Rückmeldungen erhält. Diese Rückmeldungen erlauben es, eine intuitive Verbindung zwischen der manuellen Betätigung des Bedienelements und den dadurch induzierten Aktionen zu schaffen. Weiterhin ermöglichen es diese Rückmeldungen, dass der Nutzer beispielsweise über einen aktuellen Zustand oder Modus des Bedienelements informiert wird, ohne eine Anzeige betrachten zu müssen. Dies ist insbesondere dann von Vorteil, wenn das Bedienelement in einem Fahrzeug, insbesondere einem Kraftfahrzeug, angeordnet ist und zur Steuerung beispielsweise von Kraftfahrzeugsystemen dient. Zur Bedienung muss der Fahrer seine Aufmerksamkeit nicht von der Beobachtung des umgebenden Verkehrsgeschehens weg auf das Bedienelement richten, um Informationen über den aktuellen Zustand der haptischen Nutzerschnittstelle bzw. des Bedienelements zu erhalten, sondern er erhält über die haptischen Rückmeldungen diese Informationen über den aktuellen Zustand des Bedienelements. Somit kann ein Nutzer beispielsweise anhand der ausgegebenen Rückmeldung erkennen, wann ein durch eine Eingabe in das Bedienelement erzeugter Schaltvorgang erfolgt ist. Insbesondere können Rückmeldesignale dargestellt werden, die unterschiedliche Informationen repräsentieren, beispielsweise ein erstes Rückmeldesignal, das eine korrekt erkannte Betätigung des Bedienelements repräsentiert und ein zweites Rückmeldesignal, dass eine Fehleingabe bei der Betätigung des Bedienelements repräsentiert. Insbesondere kann dadurch der haptische Eindruck bei der Betätigung beispielsweise eines Tasters zumindest annähernd simuliert werden.

Rückmeldesignale können weiterhin den korrekt erkannten Beginn einer Betätigung des Bedienelements und das korrekt erkannte Ende einer Betätigung des Bedienelements signalisieren. Dies ist immer dann von Vorteil, wenn es um die Eingabe eines Zeitintervalls geht. In diesen Fällen erfolgt vorteilhaft sobald der Beginn der Betätigung korrekt erkannt wurde, die Ausgabe eines ersten Rückmeldesignals, und sobald das Ende der Betätigung korrekt erkannt wurde, die Ausgabe eines zweiten Rückmeldesignals.

In AU 2015 101 188 A4 wird eine Eingabe bei einer Benutzerschnittstelle in Abhängigkeit von einer Reaktionszeit eines Benutzers auf ein haptisches Signal ausgewertet; eine Anpassung der Intensität des haptischen Signals in Abhängigkeit von der Reaktionszeit oder Ähnlichem wird dort nicht gelehrt.

Aufgabe der Erfindung ist es, eine verbesserte haptische Nutzerschnittstelle und ein Verfahren zur Steuerung einer solchen haptischen Nutzerschnittstelle anzugeben, die eine nutzerspezifische Bedienung des Bedienelements berücksichtigen.

Die Erfindung ergibt sich aus den Merkmalen der unabhängigen Ansprüche. Vorteilhafte Weiterbildungen und Ausgestaltungen sind Gegenstand der abhängigen Ansprüche.

Ein erster verfahrensgemäßer Aspekt der Aufgabe wird durch ein Verfahren zur Steuerung eines Aktors, der mit einem Bedienelement einer manuellen Nutzerschnittstelle verbunden ist und zur Ausgabe eines haptischen Rückmeldesignals S_{A}(t) über das Bedienelement an einen Nutzer dient, gelöst. Dabei ist in dem Bedienelement ein Sensor vorhanden, der ein Sensorsignal Sₛ(t) erfasst, das durch eine manuelle Eingabe des Nutzers als Reaktion auf das ausgegebene Rückmeldesignal S_{A}(t) erzeugt wird. Das vorgeschlagene Verfahren umfasst folgende Schritte.

In einem Schritt erfolgt nach Ausgabe eines Rückmeldesignals S_{A}(t₀) zur Zeit to durch den Aktor auf Basis des Sensorsignals Sₛ(t) für t > to ein Ermitteln einer Reaktionszeit RZ des Nutzers, wobei, sofern die ermittelte Reaktionszeit RZ kleiner als ein vorgegebener Grenzwert G_{RZ} ist, künftig auszugebende haptische Rückmeldesignale S_{A}(t) derart verändert werden, dass ihre haptisch (von einem Nutzer) fühlbare Intensität verringert ist, und sofern die ermittelte Reaktionszeit RZ größer als ein vorgegebener Grenzwert G_{RZ} ist, künftig auszugebende haptische Rückmeldesignale S_{A}(t) derart verändert werden, dass ihre haptisch (von einem Nutzer) fühlbare Intensität vergrößert ist.

In einem alternativen oder zusätzlichen Schritt erfolgt nach Ausgabe eines Rückmeldesignals S_{A}(t₀) zur Zeit to durch den Aktor auf Basis des Sensorsignals Ss(t) für t > to ein Ermitteln eines maximalen Betrags |Sₛ(t)|ₘₐₓ des Sensorsignals Ss(t), wobei, sofern der ermittelte maximale Betrag |Sₛ(t)|ₘₐₓ kleiner als ein vorgegebener Grenzwert Gssmax ist, künftig auszugebende haptische Rückmeldesignale S_{A}(t) derart verändert werden, dass ihre haptisch (von einem Nutzer) fühlbare Intensität verringert ist und, sofern der ermittelte maximale Betrag |Sₛ(t)|ₘₐₓ größer als ein vorgegebener Grenzwert G_{Ssmax} ist, künftig auszugebende haptische Rückmeldesignale S_{A}(t) derart verändert werden, dass ihre haptisch (von einem Nutzer) fühlbare Intensität vergrößert ist.

Der Begriff "Bedienelemente" wird vorliegend weit gefasst verstanden. Ein solches Bedienelement bildet die Schnittstelle, die eine manuelle Eingabe eines Nutzers aufnimmt und mit dem Sensor als Sensorsignale Ss(t) erfasst. Der Sensor ist hierzu mit dem Bedienelement geeignet verbunden. Die manuelle Eingabe wird vorteilhaft durch einen Krafteintrag, einen Momenteneintrag oder einen Druckeintrag des Nutzers in bzw. auf das Bedienelement erzeugt. Unter den Begriff "Bedienelement" fallen beispielsweise tastempfindliche Oberflächenelemente, wie beispielsweise von Touch Pads bekannt, Taster, Schalter, Computermäuse, Joysticks etc.

Als Sensor kommen grundsätzlich alle Sensoren in Betracht, die zur Erfassung einer manuellen Eingabe ausgeführt sind, insbesondere Kraftsensoren, Drucksensoren, Momentensensoren oder eine Kombination daraus. Der Sensor erfasst bei der manuellen Eingabe eines Nutzers am Bedienelement zeitabhängige Sensorsignale Ss(t). Diese Sensorsignale Ss(t) geben vorzugsweise Kräfte und/oder Momente und/oder Drücke wieder, die der Nutzer bei der Eingabe auf das Bedienelement aufbringt. Die Sensorsignale Ss(t) können insbesondere mehrdimensional sein, und somit mehrdimensionale Zustände des Bedienelements angeben, beispielsweise Positionen, Winkel, Geschwindigkeiten, Beschleunigungen des Bedienelements.

Der Begriff "Aktor" wird vorliegend weit gefasst verstanden. Darunter fallen beispielsweise Elektromotoren, piezoelektrische Elemente, Schwingspulen, Hubmagnete, etc. Der Aktor dient dazu, auf dem Bedienelement ein vom Nutzer haptisch wahrnehmbares Rückmeldesignal S_{A}(t) zu erzeugen. Vorteilhaft ist das Rückmeldesignal S_{A}(t) hinsichtlich seiner Amplitude bzw. seines Amplitudengangs, seiner Frequenz bzw. seines Frequenzgangs, seines Abklingverhaltens vorgebbar bzw. einstellbar. Ein oder mehrere zeitlich aufeinanderfolgende Rückmeldesignale S_{A}(t) signalisieren dem Nutzer beispielsweise, dass die erfolgte manuelle Eingabe aufgrund ihrer Eingabeintensität und/oder zeitlichen Länge zu einer Änderung des Zustandes des Bedienelements geführt hat, beispielsweise das Bedienelement einen neuen Schaltzustand eingenommen oder erzeugt hat, und/oder vermitteln dem Nutzer den Anfang und das Ende einer manuellen Eingabe in das Bedienelement.

Das vorgeschlagene Verfahren dient dazu, die haptischen Rückmeldesignale S_{A}(t) automatisch an Eingabecharakteristika des jeweiligen Nutzers anzupassen, so dass für jeden Nutzer individuell sichergestellt wird, dass er ausgegebene Rückmeldesignale S_{A}(t₀) sicher und zuverlässig wahrnimmt.

Vorteilhaft können die derart ermittelten, auf einen jeweiligen Nutzer angepassten Rückmeldesignale S_{A}(t) abrufbar gespeichert werden. Vorteilhaft wird eine Nutzerschnittstelle, die zumindest ein solches Bedienelement aufweist, spezifisch für den jeweiligen Nutzer initialisiert. Somit kann sichergestellt werden, dass im Fall, dass mehrere Nutzer für Eingaben in das Bedienelement infrage kommen, dass für jeden Nutzer die auf ihn optimierten Rückmeldesignale S_{A}(t) ausgegeben werden.

Gemäß einer ersten Alternative des Verfahrens wird dies erreicht, indem nach Ausgabe eines Rückmeldesignals S_{A}(t₀) zur Zeit to durch den Aktor auf Basis des erfassten Sensorsignals Ss(t) für t > to eine Reaktionszeit RZ des Nutzers ermittelt wird. Vorteilhaft wird die Reaktionszeit RZ in einem vorgegebenen Zeitintervall beginnend von t₀ ermittelt. Hierzu wird vorteilhaft das Sensorsignal Sₛ(t) für t > t₀ ausgewertet. Beispielsweise kann die Reaktionszeit RZ die Zeit sein, die von der Zeit t₀ bis zum Erreichen eines Maximums oder Minimums des Sensorsignals Ss(t) für t > to vergeht. Die Kriterien zur Ermittlung der Reaktionszeit RZ können entsprechend Aufgabenstellung abweichend davon gewählt werden. Die Reaktionszeit RZ ist mithin die Zeit, die seit der Ausgabe des Rückmeldesignals S_{A}(t₀) zur Zeit t₀ vergeht, bis eine dadurch getriggerte Reaktion des Nutzers erfolgt, welche anhand des Sensorsignals Ss(t) für t > to erkennbar ist.

Entsprechend der Definition der Reaktionszeit RZ wird ein Grenzwert G_{RZ} vorgegeben, der vorteilhaft eine normale, erwartbare Reaktionszeit definiert. Der Grenzwert G_{RZ} wird je nach Anforderung und Aufgabenstellung entsprechend vorgegeben. Vorteilhaft wird der Grenzwert G_{RZ} aus dem Bereich 20 bis 60 ms oder aus dem Bereich 30 bis 50 ms gewählt. Ist die ermittelte Reaktionszeit RZ kleiner als der vorgegebene Grenzwert G_{RZ}, so ist die haptisch fühlbare Intensität des ausgegebenen Rückmeldesignals S_{A}(t) zu hoch gewählt, sodass in diesem Fall künftig auszugebende haptische Rückmeldesignale S_{A}(t) automatisch derart verändert werden, dass ihre haptisch fühlbare Intensität verringert ist.

Ist hingegen die ermittelte Reaktionszeit RZ größer als der vorgegebene Grenzwert G_{RZ}, so kann davon ausgegangen werden, dass das Rückmeldesignal S_{A}(t₀) vom Nutzer nicht oder nicht richtig wahrgenommen wurde. Als Reaktion werden künftig auszugebende haptische Rückmeldesignale S_{A}(t) automatisch derart verändert, dass ihre haptisch fühlbare Intensität vergrößert ist.

In einer zweiten Alternative oder zusätzlich zur ersten Alternative wird nach Ausgabe eines Rückmeldesignals S_{A}(t₀) zur Zeit to durch den Aktor auf Basis des Sensorsignals Ss(t) für t > to ein maximaler Betrag |Sₛ(t)|ₘₐₓ des Sensorsignals Ss(t) ermittelt. Vorteilhaft wird der maximale Betrag |Sₛ(t)|ₘₐₓ in einem vorgegebenen Zeitintervall beginnend von to ermittelt. Weiterhin wird ein Grenzwert G_{Ssmax} vorgegeben, der vorteilhaft einen normalen, erwartbaren Maximalbetrag |Sₛ(t)|ₘₐₓ des Sensorsignals Ss(t) definiert. Der Grenzwert G_{Ssmax} wird je nach Anforderung und Aufgabenstellung entsprechend vorgegeben.

Ist der ermittelte maximale Betrag |Sₛ(t)|ₘₐₓ kleiner als der vorgegebener Grenzwert G_{Ss}-ₘₐₓ, dann kann man davon ausgehen, dass das Rückmeldesignal S_{A}(t₀) zur Zeit to vom Nutzer außergewöhnlich gut wahrgenommen wurde. Ein künftig auszugebendes haptisches Rückmeldesignal S_{A}(t) kann daher automatisch derart verändert werden, dass seine haptisch fühlbare Intensität gegenüber dem bisherigen Rückmeldesignal S_{A}(t₀) zur Zeit to verringert ist. Ist hingegen der ermittelte maximale Betrag |Sₛ(t)|ₘₐₓ größer als der vorgegebene Grenzwert G_{Ssmax}, werden künftig auszugebende haptische Rückmeldesignale S_{A}(t) derart verändert, dass ihre haptisch fühlbare Intensität vergrößert ist.

Vorteilhaft werden entsprechend die künftig auszugebenden haptischen Rückmeldesignale S_{A}(t) in einem vorgegebenen Intensitätsschritt verändert. Das Verfahren wird dann vorteilhaft bei Ausgabe des veränderten Rückmeldesignals S_{A}(t) erneut durchlaufen, sodass eine kontinuierliche Optimierung auf den jeweiligen Nutzer erfolgt. Vorteilhaft erfolgt eine Änderung des Rückmeldesignals S_{A}(t) in Abhängigkeit von dem erfassten Sensorsignal Sₛ(t) für t > to und/oder einer ermittelten Abweichung der sich aus dem Sensorsignal Sₛ(t) für t > to ergebenden Reaktionszeit RZ von dem Grenzwert G_{RZ} und/oder eine ermittelten Abweichung des sich aus dem Sensorsignal Ss(t) für t > to ergebenden maximalen Betrags |Sₛ(t)|ₘₐₓ von dem Grenzwert G_{Ssmax'}.

Die haptisch fühlbare Intensität des auszugebenden haptischen Rückmeldesignals kann durch verschiedene Maßnahmen verringert oder erhöht werden. Beispielsweise kann das Rückmeldesignal S_{A}(t) in seiner Amplitude/seinem Amplitudenspektrum und/oder seiner Frequenz/seinem Frequenzspektrum und/oder seinem zeitlichen Anstiegs- oder Abfallverhalten und/oder seinem Dämpfungsverhalten verändert werden.

Werden bei einer Eingabe des Nutzers am Bedienelement zwei oder mehr zeitlich hintereinander folgende Rückmeldesignale S_{A}(t) ausgegeben, beispielsweise, um so dem Nutzer verschiedene Schaltzustände des Bedienelements zu signalisieren, wird vorteilhaft für jedes der ausgegebenen Rückmeldesignale S_{A}(t₀₁), S_{A}(t₀₂), S_{A}(t₀₃), ... das vorstehend beschriebene Verfahren ausgeführt. Somit ergeben sich durch Auswertung der auf die jeweiligen Rückmeldesignale S_{A}(t) folgenden Sensorsignale Ss(t) zwei oder mehr ermittelte Reaktionszeiten RZ₀₁, RZ₀₂, RZ₀₃ ... und zwei oder mehr maximale Beträge |S_{s,01}(t)|ₘₐₓ, |S_{s,02}(t)|ₘₐₓ, |S_{S,03}(t)|ₘₐₓ, .... Vorteilhaft werden diese jeweils gemittelt und mit den Grenzwerten G_{RZ} bzw. G_{Ssmax} verglichen. Auf Basis dieses Vergleichs werden die künftig auszugebenden haptischen Rückmeldesignale gleichsam, wie vorstehend beschrieben, verändert. Alternativ hierzu können auch nur die Sensorsignale Ss(t), die zeitlich nach Ausgabe eines der Rückmeldesignale S_{A}(t₀₁), S_{A}(t₀₂), S_{A}(t₀₃), ... erfasst werden, wie vorstehend angegeben ausgewertet werden, wobei alle künftig auszugebenden haptischen Rückmeldesignale S_{A}(t) darauf basierend wie vorstehend beschrieben verändert werden.

Das vorgeschlagene Verfahren wird vorteilhaft erst nach einer Anforderung eines Nutzers ausgeführt. Diese Anforderung kann durch eine manuelle oder akustische Eingabe in eine entsprechende Eingabeschnittstelle erfolgen. Die vorstehend beschriebene Anpassung der Rückmeldesignale S_{A}(t) erfolgt in diesem Fall nach einer expliziten Anforderung des jeweiligen Nutzers. Alternativ hierzu kann das vorgeschlagene Verfahren automatisch bei jeder manuellen Eingabe in die Nutzerschnittstelle erfolgen.

Ein weiterer Aspekt der Erfindung betrifft eine Nutzerschnittstelle umfassend: ein Bedienelement zur manuellen Eingabe durch einen Nutzer, ein mit dem Bedienelement verbundener Aktor zur Ausgabe eines haptischen Rückmeldesignals S_{A}(t) über das Bedienelement an den Nutzer, einen mit dem Bedienelement verbundenen Sensor, der ein Sensorsignal Ss(t) erfasst, das durch eine manuelle Eingabe des Nutzers in das Bedienelement als Reaktion auf das ausgegebene Rückmeldesignal S_{A}(t) erzeugt wird, und ein mit dem Aktor und dem Sensor verbundenes Steuergerät.

Das Steuergerät ist derart ausgeführt und eingerichtet, dass nach Ausgabe eines Rückmeldesignals S_{A}(t₀) zur Zeit to auf Basis des Sensorsignals Ss(t) für t > to eine Reaktionszeit RZ des Nutzers ermittelt wird, wobei, sofern die ermittelte Reaktionszeit RZ kleiner als ein vorgegebener Grenzwert G_{RZ} ist, künftig auszugebenden haptischen Rückmeldesignale S_{A}(t) derart verändert werden, dass ihre haptisch fühlbare Intensität verringert ist, und sofern die ermittelte Reaktionszeit RZ größer als ein vorgegebener Grenzwert G_{RZ} ist, künftig auszugebenden haptischen Rückmeldesignale S_{A}(t) derart verändert werden, dass ihre haptisch fühlbare Intensität vergrößert ist, und/oder nach Ausgabe eines Rückmeldesignals S_{A}(t₀) zur Zeit to auf Basis des Sensorsignals Ss(t) für t > to ein maximaler Betrag |Sₛ(t)|ₘₐₓ des Sensorsignals Ss(t) ermittelt wird, wobei, sofern der ermittelte maximale Betrag |Sₛ(t)|ₘₐₓ kleiner als ein vorgegebener Grenzwert G_{Ssmax} ist, künftig auszugebende haptische Rückmeldesignale S_{A}(t) derart verändert werden, dass ihre haptisch fühlbare Intensität verringert ist, und sofern der ermittelte maximale Betrag |Sₛ(t)|ₘₐₓ größer als ein vorgegebener Grenzwert G_{Ssmax} ist, künftig auszugebende haptische Rückmeldesignale S_{A}(t) derart verändert werden, dass ihre haptisch fühlbare Intensität vergrößert ist. Das Steuergerät umfasst vorteilhaft einen Prozessor und eine Speichereinheit. Vorteile und bevorzugte Weiterbildungen der vorgeschlagenen Nutzerschnittstelle ergeben sich durch sinngemäße und analoge Übertragung der im Zusammenhang mit dem vorgeschlagenen Verfahren gemachten Ausführungen.

Ein weiterer Aspekt der Erfindung betrifft ein Fahrzeug mit einer Nutzerschnittstelle, wie vorstehend beschrieben.

Weitere Vorteile, Merkmale und Einzelheiten ergeben sich aus der nachfolgenden Beschreibung, in der - gegebenenfalls unter Bezug auf die Zeichnung - zumindest ein Ausführungsbeispiel im Einzelnen beschrieben ist. Gleiche, ähnliche und/oder funktionsgleiche Teile sind mit gleichen Bezugszeichen versehen.

Es zeigen:
- Fig. 1: eine schematisierte Darstellung einer erfindungsgemäßen Nutzerschnittstelle 200, und
- Fig. 2: eine schematisierte Darstellung eines vorgeschlagenen Verfahrens.

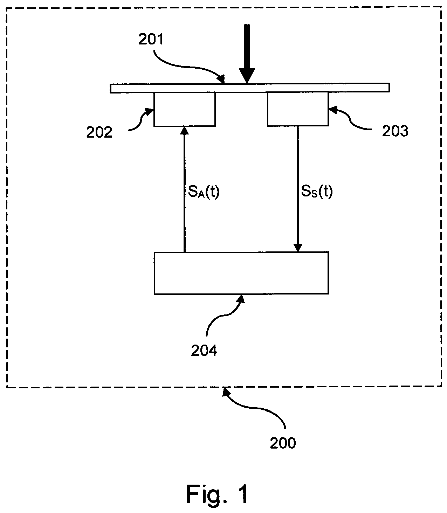

**Fig. 1** zeigt eine schematisierte Darstellung einer erfindungsgemäßen Nutzerschnittstelle 200. Die Nutzerschnittstelle 200 umfasst ein als Trägerplatte ausgestaltetes Bedienelement 201 zur manuellen Eingabe eines Nutzers. Vorliegend berührt der Nutzer die Oberfläche des Bedienelements 201 in der Zeichnung von oben her, und bringt eine in der Zeichnung nach unten gerichtete Kraft (repräsentiert durch den Pfeil) in das Bedienelement 201 ein. Mit dem Bedienelement 201 verbunden ist ein Aktor 202, beispielsweise aufweisend eine Schwingspule oder ein piezoelektrisches Element (nicht dargestellt), mittels dem über das Bedienelement 201 an den Nutzer ein von ihm haptisch wahrnehmbares Rückmeldesignal S_{A}(t) ausgebbar ist. Das Rückmeldesignal S_{A}(t) weist vorliegend ein vorgegebenes Frequenzspektrum, einen vorgegebenen Amplitudenzeitverlauf, ein vorgegebenes Anstiegs- und Abklingverhalten auf. Das Rückmeldesignal S_{A}(t) steuert den Aktor 202 an und wird von diesem in mechanische Bewegungen, die von dem Nutzer haptisch wahrnehmbar sind, umgesetzt.

Das Bedienelement 202 ist weiterhin mit einem Sensor 203 verbunden, der ein Sensorsignal Sₛ(t) erfasst, das durch eine manuelle Eingabe des Nutzers in das Bedienelement 201, insbesondere als Reaktion auf das ausgegebene Rückmeldesignal S_{A}(t) erzeugt wird. Der Sensor 203 ist vorliegend vorteilhaft ein Kraftsensor. Insbesondere vorteilhaft ist der Sensor 203 vorliegend identisch mit dem Aktor 202, also als Schwingspuleneinheit ausgeführt.

Die Nutzerschnittstelle 200 umfasst weiterhin ein mit dem Aktor 202 und dem Sensor 203 verbundenes Steuergerät 204. Dieses Steuergerät 204 ist derart ausgeführt und eingerichtet, dass nach Ausgabe eines Rückmeldesignals S_{A}(t₀) zur Zeit to auf Basis des Sensorsignals Ss(t) für t > to eine Reaktionszeit RZ des Nutzers ermittelt wird, wobei, sofern die ermittelte Reaktionszeit RZ kleiner als ein vorgegebener Grenzwert G_{RZ} ist, künftig auszugebende haptische Rückmeldesignale S_{A}(t) derart verändert werden, dass ihre haptisch fühlbare Intensität verringert ist, und, sofern die ermittelte Reaktionszeit RZ größer als ein vorgegebener Grenzwert G_{RZ} ist, künftig auszugebende haptische Rückmeldesignale S_{A}(t) derart verändert werden, dass ihre haptisch fühlbare Intensität vergrößert ist. Dies erfolgt vorliegend durch Vergrößerung der Amplitude und des Frequenzgangs des Rückmeldesignals S_{A}(t).

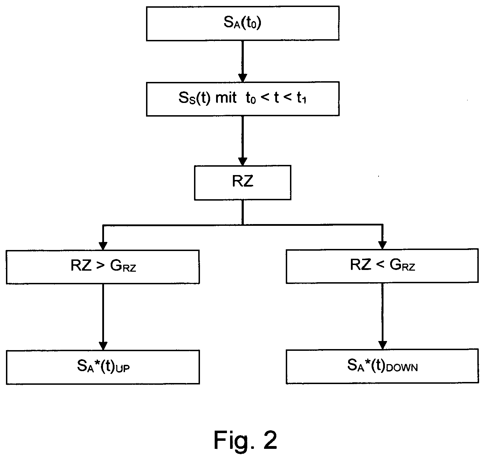

**Fig. 2** zeigt eine schematisierte Darstellung eines vorgeschlagenen Verfahrens zur Steuerung eines Aktors 202, der mit einem Bedienelement 201 einer manuellen Nutzerschnittstelle 200 verbunden ist und zur Ausgabe eines haptischen Rückmeldesignals S_{A}(t) über das Bedienelement 201 an einen Nutzer dient, wobei in dem Bedienelement 201 ein Sensor 203 vorhanden ist, der ein Sensorsignal Ss(t) erfasst, das durch eine manuelle Eingabe des Nutzers als Reaktion auf das ausgegebene Rückmeldesignal S_{A}(t) erzeugt wird.

Das Verfahren wird vorliegend durch eine entsprechende Eingabe des Nutzers gestartet. Alle weiteren Schritte des Verfahrens werden automatisiert ausgeführt.

Zunächst wird zu einer Zeit to mittels des Aktors 202 über das Bedienelement 201 ein Rückmeldesignal S_{A}(t₀) an den Nutzer ausgegeben. Mit dem Sensor 203 werden daraufhin für to < t < t₁ Sensorsignale Sₛ(t) erfasst, die durch eine manuelle Eingabe des Nutzers in das Bedienelement als Reaktion auf das ausgegebene Rückmeldesignal S_{A}(t₀) erzeugt werden. Der Zeitpunkt t₁ wird entsprechend vorgegeben. Auf Basis des Sensorsignals Ss(t) to < t < t₁ wird in einem weiteren Schritt eine Reaktionszeit RZ des Nutzers ermittelt. Dies erfolgt vorliegend durch die Ermittlung der Zeitspanne zwischen der Zeit to und der Zeit, zu der der Betrag des Sensorsignals Ss(t) innerhalb des Intervalls [t₀, t₁] maximal ist.

Anschließend wird die Reaktionszeit RZ mit einem vorgegebenen Grenzwert G_{RZ} verglichen. Sofern die ermittelte Reaktionszeit RZ kleiner als der vorgegebene Grenzwert G_{RZ} ist, werden künftig auszugebende haptische Rückmeldesignale S_{A}*(t)_{DOWN} derart verändert, dass ihre haptisch fühlbare Intensität verringert ist, und sofern die ermittelte Reaktionszeit RZ größer als ein vorgegebener Grenzwert G_{RZ} ist, werden künftig auszugebende haptische Rückmeldesignale S_{A}*(t)_{UP} derart verändert, dass ihre haptisch fühlbare Intensität vergrößert ist.

Sofern die ermittelte Reaktionszeit RZ gleich dem Grenzwert G_{RZ} ist, wird das Rückmeldesignal bei künftigen Ausgaben nicht geändert.

Vorteilhaft wird das für den jeweiligen Nutzer entsprechend veränderte Rückmeldesignal S_{A}*(t) dem Nutzer zugehörig gespeichert.

Obwohl die Erfindung im Detail durch bevorzugte Ausführungsbeispiele näher illustriert und erläutert wurde, so ist die Erfindung nicht durch die offenbarten Beispiele eingeschränkt und andere Variationen können vom Fachmann hieraus abgeleitet werden, ohne den Schutzumfang der Erfindung,wie sie in den nachfolgenden Ansprüchen definiert ist, zu verlassen. Es ist daher klar, dass eine Vielzahl von Variationsmöglichkeiten existiert. Es ist ebenfalls klar, dass beispielhaft genannte Ausführungsformen wirklich nur Beispiele darstellen, die nicht in irgendeiner Weise als Begrenzung etwa des Schutzbereichs, der Anwendungsmöglichkeiten oder der Konfiguration der Erfindung aufzufassen sind. Vielmehr versetzen die vorhergehende Beschreibung und die Figurenbeschreibung den Fachmann in die Lage, die beispielhaften Ausführungsformen konkret umzusetzen, wobei der Fachmann in Kenntnis des offenbarten Erfindungsgedankens vielfältige Änderungen, beispielsweise hinsichtlich der Funktion oder der Anordnung einzelner, in einer beispielhaften Ausführungsform genannter Elemente, vornehmen kann, ohne den Schutzbereich zu verlassen, der durch die Ansprüche niert wird.

## Patentansprüche

1. Verfahren zur Steuerung eines Aktors (202), der mit einem Bedienelement (201) einer manuellen Nutzerschnittstelle (200) verbunden ist und zur Ausgabe eines haptischen Rückmeldesignals S_{A}(t) über das Bedienelement (201) an einen Nutzer dient, wobei in dem Bedienelement (201) ein Sensor (203) vorhanden ist, der ein Sensorsignal Sₛ(t) erfasst, das durch eine manuelle Eingabe des Nutzers als Reaktion auf das ausgegebene Rückmeldesignal S_{A}(t) erzeugt wird, mit folgenden Schritten:
- nach Ausgabe eines Rückmeldesignals S_{A}(t₀) zur Zeit to durch den Aktor (202) auf Basis des Sensorsignals Sₛ(t) für t > to Ermitteln einer Reaktionszeit RZ des Nutzers,
- sofern die ermittelte Reaktionszeit RZ kleiner als ein vorgegebener Grenzwert G_{RZ} ist, werden künftig auszugebende haptische Rückmeldesignale S_{A}(t) derart verändert, dass ihre haptisch fühlbare Intensität verringert ist und, sofern die ermittelte Reaktionszeit RZ größer als ein vorgegebener Grenzwert G_{RZ} ist, werden künftig auszugebende haptische Rückmeldesignale S_{A}(t) derart verändert, dass ihre haptisch fühlbare Intensität vergrößert ist, und/oder
- nach Ausgabe eines Rückmeldesignals S_{A}(t₀) zur Zeit to durch den Aktor auf Basis des Sensorsignals Ss(t) für t > to Ermitteln eines maximalen Betrags |Sₛ(t)|ₘₐₓ des Sensorsignals Ss(t),
- sofern der ermittelte maximale Betrag |Sₛ(t)|ₘₐₓ kleiner als ein vorgegebener Grenzwert G_{Ssmax} ist, werden künftig auszugebende haptische Rückmeldesignale S_{A}(t) derart verändert, dass ihre haptisch fühlbare Intensität verringert ist und, sofern der ermittelte maximale Betrag |Sₛ(t)|ₘₐₓ größer als ein vorgegebener Grenzwert G_{Ssmax} ist, werden künftig auszugebende haptische Rückmeldesignale S_{A}(t) derart verändert, dass ihre haptisch fühlbare Intensität vergrößert ist.

2. Verfahren nach Anspruch 1,
bei dem das geänderte haptische Rückmeldesignal S_{A}(t) eine geänderte Amplitude, und/oder eine geänderte Frequenz, und/oder eine geänderte Dämpfung aufweist.

3. Verfahren nach Anspruch 1 oder 2,
bei dem der Aktor (202) eine Schwingspule und/oder ein Piezoelement umfasst.

4. Verfahren nach einem der Ansprüche 1 bis 3,
bei dem der Grenzwert G_{RZ} aus dem Bereich 20 bis 60 ms oder aus dem Bereich 30 bis 50 ms gewählt ist.

5. Verfahren nach einem der Ansprüche 1 bis 4,
bei dem das Verfahren automatisch ausgeführt wird.

6. Verfahren nach einem der Ansprüche 1 bis 4,
bei dem das Verfahren erst nach einer Nutzereingabe zum Start des Verfahrens automatisch ausgeführt wird.

7. Nutzerschnittstelle (200) umfassend:
- ein Bedienelement (201) zur manuellen Eingabe durch einen Nutzer,
- ein mit dem Bedienelement (201) verbundener Aktor (202) zur Ausgabe eines haptischen Rückmeldesignals S_{A}(t) über das Bedienelement (201) an den Nutzer,
- einen mit dem Bedienelement (201) verbundenen Sensor (203), der ein Sensorsignal Sₛ(t) erfasst, das durch eine manuelle Eingabe des Nutzers in das Bedienelement (201) als Reaktion auf das ausgegebene Rückmeldesignal S_{A}(t) erzeugt wird, und
- ein mit dem Aktor (202) und dem Sensor (203) verbundenes Steuergerät (204), das derart ausgeführt und eingerichtet ist, dass
- nach Ausgabe eines Rückmeldesignals S_{A}(t₀) zur Zeit to auf Basis des Sensorsignals Ss(t) für t > to eine Reaktionszeit RZ des Nutzers ermittelt wird, wobei, sofern die ermittelte Reaktionszeit RZ kleiner als ein vorgegebener Grenzwert G_{RZ} ist, künftig auszugebende haptische Rückmeldesignale S_{A}(t) derart verändert werden, dass ihre haptisch fühlbare Intensität verringert ist, und sofern die ermittelte Reaktionszeit RZ größer als ein vorgegebener Grenzwert G_{RZ} ist, künftig auszugebende haptische Rückmeldesignale S_{A}(t) derart verändert werden, dass ihre haptisch fühlbare Intensität vergrößert ist, und/oder
- nach Ausgabe eines Rückmeldesignals S_{A}(t₀) zur Zeit to auf Basis des Sensorsignals Ss(t) für t > to ein maximaler Betrag |Sₛ(t)|ₘₐₓ des Sensorsignals Ss(t) ermittelt wird, wobei, sofern der ermittelte maximale Betrag |Sₛ(t)|ₘₐₓ kleiner als ein vorgegebener Grenzwert G_{Ssmax} ist, künftig auszugebende haptische Rückmeldesignale S_{A}(t) derart verändert werden, dass ihre haptisch fühlbare Intensität verringert ist, und, sofern der ermittelte maximale Betrag |Sₛ(t)|ₘₐₓ größer als ein vorgegebener Grenzwert G_{Ssmax} ist, künftig auszugebende haptische Rückmeldesignale S_{A}(t) derart verändert werden, dass ihre haptisch fühlbare Intensität vergrößert ist.

8. Nutzerschnittstelle nach Anspruch 7,
bei dem das geänderte haptische Rückmeldesignal S_{A}(t) eine geänderte Amplitude, und/oder eine geänderte Frequenz, und/oder eine geänderte Dämpfung aufweist.

9. Nutzerschnittstelle nach Anspruch 7 oder 8,
bei dem der Aktor (202) eine Schwingspule und/oder ein Piezoelement umfasst.

10. Fahrzeug mit einer Nutzerschnittstelle (200) nach einem der Ansprüche 7 bis 9.

## Claims

1. Method for controlling an actuator (202), which is connected to a control (201) of a manual user interface (200) and used to output a haptic feedback signal S_{A}(t) to a user via the control (201), wherein a sensor (203) detecting a sensor signal Ss(t) generated by a manual input of the user in response to the output feedback signal S_{A}(t) is provided in the control (201), the method comprising the following steps:
- following the output of a feedback signal S_{A}(t₀) at the time to by the actuator (202) on the basis of the sensor signal Ss(t) for t > to, the determination of a reaction time RZ of the user,
- if the determined reaction time RZ is shorter than a preset limit value G_{RZ}, haptic feedback signals S_{A}(t) to be output in future are changed in such a way that their haptically perceptible integrity is reduced, and if the determined reaction time RZ is longer than a preset limit value G_{RZ}, haptic feedback signals S_{A}(t) to be output in future are changed in such a way that their haptically perceptible integrity is increased, and/or
- following the output of a feedback signal S_{A}(t₀) at the time to by the actuator on the basis of the sensor signal Ss(t) for t > to, the determination of a maximum value |Sₛ(t)|ₘₐₓ of the sensor signal Ss(t),
- if the determined maximum value |Sₛ(t)|ₘₐₓ is less than a preset limit value G_{Ssmax}, haptic feedback signals S_{A}(t) to be output in future are changed in such a way that their haptically perceptible integrity is reduced, and if the determined maximum value |Sₛ(t)|ₘₐₓ is more than a preset limit value G_{Ssmax}, haptic feedback signals S_{A}(t) to be output in future are changed in such a way that their haptically perceptible integrity is increased.

2. Method according to claim 1,
wherein the changed haptic feedback signal S_{A}(t) has a changed amplitude and/or a changed frequency and/or a changed attenuation.

3. Method according to claim 1 or 2,
wherein the actuator (202) comprises a moving coil and/or a piezoelectric element.

4. Method according to any of claims 1 to 3,
wherein the limit value G_{RZ} is selected from the range of 20 to 60 ms or from the range of 30 to 50 ms.

5. Method according to any of claims 1 to 4,
wherein the method is executed automatically.

6. Method according to any of claims 1 to 4,
wherein the method is executed automatically only after a user input for starting the method.

7. User interface (200), comprising:
- a control (201) for manual input by a user,
- an actuator (202) connected to the control (201) for outputting a haptic feedback signal S_{A}(t) to the user via the control (201),
- a sensor (203) connected to the control (201) and detecting a sensor signal Ss(t) generated by a manual input of the user into the control (201) in response to the output feedback signal S_{A}(t), and
- a control unit (204) connected to the actuator (202) and the sensor (203), the control unit (204) being configured and arranged such that
- following the output of a feedback signal S_{A}(t₀) at the time to on the basis of the sensor signal Ss(t) for t > to, a reaction time RZ of the user is determined, wherein, if the determined reaction time RZ is shorter than a preset limit value G_{RZ}, haptic feedback signals S_{A}(t) to be output in future are changed in such a way that their haptically perceptible integrity is reduced, and if the determined reaction time RZ is longer than a preset limit value G_{RZ}, haptic feedback signals S_{A}(t) to be output in future are changed in such a way that their haptically perceptible integrity is increased, and/or
- following the output of a feedback signal S_{A}(t₀) at the time to on the basis of the sensor signal Ss(t) for t > to, a maximum value |Sₛ(t)| ₘₐₓ of the sensor signal Ss(t) is determined, wherein, if the determined maximum value |Sₛ(t)|ₘₐₓ is less than a preset limit value G_{Ssmax}, haptic feedback signals S_{A}(t) to be output in future are changed in such a way that their haptically perceptible integrity is reduced, and if the determined maximum value |Sₛ(t)|ₘₐₓ is more than a preset limit value G_{Ssmax}, haptic feedback signals S_{A}(t) to be output in future are changed in such a way that their haptically perceptible integrity is increased.

8. User interface according to claim 7,
wherein the changed haptic feedback signal S_{A}(t) has a changed amplitude and/or a changed frequency and/or a changed attenuation.

9. User interface according to claim 7 or 8,
wherein the actuator (202) comprises a moving coil and/or a piezoelectric element.

10. Vehicle with a user interface (200) according to any of claims 7 to 9.

## Revendications

1. Procédé de commande d'un actionneur (202), qui est relié à un élément de commande (201) d'une interface utilisateur manuelle (200) et sert à délivrer un signal de rétroaction haptique S_{A}(t) par l'intermédiaire de l'élément de commande (201) à l'utilisateur, dans l'élément de commande (201) est disposé un capteur (203) qui détecte un signal de capteur Ss(t), qui est produit par une saisie manuelle de l'utilisateur en tant que réaction au signal de rétroaction haptique délivré S_{A}(t), comprenant les étapes suivantes :
- après la sortie d'un signal de rétroaction haptique S_{A}(t) au temps to, déterminer un temps de réaction de RZ de l'utilisateur par l'actionneur (202) sur la base du signal de détecteur Ss(t) pour t > to,
- dans la mesure où le temps de réaction RZ est inférieur à une valeur limite prédéfinie G_{RZ}, les signaux de rétroaction haptique S_{A}(t) à délivrer à l'avenir seront modifiés de telle sorte que leur intensité tactile haptiquement soit réduite, dans la mesure où le temps de réaction RZ est supérieur à une valeur limite prédéfinie G_{RZ}, les signaux de rétroaction haptique à délivrer à l'avenir S_{A}(t) sont modifiés de telle sorte que leur intensité tactile haptiquement soit augmentée, et/ou
- après la sortie d'un signal de rétroaction S_{A}(t) au temps to, déterminer une valeur maximale |Sₛ(t)|ₘₐₓ du signal de capteur SS(t),
- dans la mesure où la valeur maximale déterminée |Sₛ(t)|ₘₐₓ est inférieure à une valeur limite prédéfinie G_{Ssmax}, les signaux de rétroaction haptique S_{A}(t) à délivrer à l'avenir sont modifiés de telle sorte que leur intensité tactile haptiquement soit réduite et, dans la mesure où la valeur maximale déterminée |Sₛ(t)|ₘₐₓ est supérieure à une valeur limite prédéfinie G_{Ssmax}, les signaux de rétroaction haptique S_{A}(t) à délivrer sont modifiés de telle sorte que leur intensité tactile haptiquement soit augmentée.

2. Procédé selon la revendication 1, le signal de rétroaction haptique modifié S_{A}(t) présentant une amplitude modifiée, et/ou une fréquence modifiée et/ou un amortissement modifié.

3. Procédé selon la revendication 1 ou 2, l'actionneur (202) comprenant une bobine mobile et/ou un élément piézoélectrique.

4. Procédé selon l'une quelconque des revendications 1 à 3, la valeur limite G_{RZ} étant sélectionnée dans la plage comprise entre 20 et 60 ms ou dans la plage comprise entre 30 et 50 ms.

5. Procédé selon l'une quelconque des revendications 1 à 4, le procédé étant exécuté automatiquement.

6. Procédé selon l'une quelconque des revendications 1 à 4, le procédé étant exécuté seulement après une saisie de l'utilisateur pour démarrer le procédé automatiquement.

7. Interface utilisateur (200) comprenant :
- un élément de commande (201) servant à la saisie manuelle par un utilisateur,
- un actionneur (202) relié à l'élément de commande (201) servant à délivrer un signal de rétroaction haptique S_{A}(t) par l'intermédiaire de l'élément de commande (201) à l'utilisateur,
- un capteur (203) relié à l'élément de commande (201), qui comprend un signal de capteur Ss(t) qui est produit par une entrée manuelle de l'utilisateur dans l'élément de commande (201) en tant que réaction au signal de rétroaction haptique délivré S_{A}(t), et
- un appareil de commande (204) reliée à l'actionneur (202) et au capteur (203) et conçu de manière à ce que
- après la sortie d'un signal de rétroaction haptique S_{A}(t) à un temps to sur la base du signal de capteur Ss(t) pour t > to, un temps de réaction RZ de l'utilisateur est déterminé, dans la mesure où le temps de réaction déterminé RZ est inférieur à une valeur limite prédéfinie G_{RZ}, les signaux de rétroaction haptique à délivrer à l'avenir seront modifiés de telle sorte que leur intensité tactile haptiquement soit réduite et dans la mesure où le temps de réaction déterminé RZ est supérieur à une valeur limite prédéfinie G_{RZ}, les signaux de rétroaction haptique à délivrer à l'avenir S_{A}(t) sont modifiés de telle sorte que leur intensité tactile haptiquement soit augmentée, et/ou
- après la sortie d'un signal de rétroaction haptique S_{A}(t) au temps to sur la base du signal de capteur Ss(t) pour t > to une valeur maximale définie |Sₛ(t)|ₘₐₓ est inférieure à une valeur limite prédéfinie G_{Ssmax}, les signaux de rétroaction haptique S_{A}(t) à délivrer dans le future sont modifiés de telle sorte que leur intensité tactile haptiquement soit réduite, dans la mesure où la valeur maximale déterminée Sₛ(t)|ₘₐₓ est supérieure à une valeur limite prédéfinie G_{Ssmax}, les signaux de rétroaction haptique à délivrer à l'avenir S_{A}(t) seront modifiés de telle sorte que leur intensité tactile haptiquement soit augmentée.

8. Interface utilisateur selon la revendication 7, le signal de rétroaction haptique modifié S_{A}(t) présentant une amplitude modifiée et/ou un amortissement modifié.

9. Interface utilisateur selon la revendication 7 ou 8, l'actionneur (202) comprenant une bobine mobile et/ou un élément piézoélectrique.

10. Véhicule comprenant une interface utilisateur (200) selon l'une quelconque des revendications 7 à 9.
